# EUROPEAN PATENT APPLICATION

(11) **EP 4 418 334 A1**
(43) Date of publication of application: **21.08.2024**
(21) Application number: 24157873.1
(22) Date of filing: 15.02.2024
(51) Int. Cl.: H01L 33/00

(54) **LED DEVICE FORMATION USING RELEASABLE INORGANIC WAFER BOND**

(30) Priority: 16.02.2023 US 202318110699
(71) Applicant: Lumileds LLC, San Jose, CA 95131 (US)
(72) Inventor: Epler, John Edward, San José (US)
(74) Representative: Cohausz & Florack

(57) **Abstract**

Methods of manufacturing a light emitting diode (LED) comprising bonding a transparent support wafer to a growth wafer are described. The transparent support wafer has a laser lift-off (LLO) release layer and inorganic bonding layer. The growth wafer has a matching inorganic bonding layer which is bonded to the inorganic bonding layer of the transparent support wafer. After processing, the LLO release layer is removed, separating the transparent support wafer and device wafer, and making the transparent support wafer available for reuse.

## Description

### TECHNICAL FIELD

Embodiments of the disclosure generally relate to light emitting diodes (LEDs) and methods of manufacturing the same. More particularly, embodiments of the disclosure are directed methods of manufacturing LEDs using releasable organic wafer bonding.

### BACKGROUND

A light emitting diode (LED) is a semiconductor light source that emits visible light when current flows through it. LEDs combine a p-type semiconductor with an n-type semiconductor. LEDs commonly use a III-V group compound semiconductor. A III-V group compound semiconductor provides stable operation at a higher temperature than devices that use other semiconductors. The III-V group compound is typically formed on a substrate formed of sapphire aluminum oxide (Al₂O₃) or gallium arsenide (GaAs). For example, one or more III-nitride materials, such as GaN, can be epitaxially-grown on a substrate or wafer to prepare semiconductor layers. The substrate may remain as part of a final product, or may be removed during processing.

During manufacturing, it is common for growth substrates (also referred to as growth wafers) to be removed before completion of the processing of the semiconductor layers (also referred to as device layers). To complete the process, the semiconductor layers (also referred to as device layers) need to be supported by some support material. To temporarily hold the semiconductor layers (also referred to as device layers) to a support structure, releasable organic bonding of the semiconductor layers to a silicon, sapphire, or glass support wafer is widely practiced in the semiconductor industry. Toray, MMI, Brewer Sciences, and 3M are a few of the companies offering proprietary recipes and tools to bond a device wafer to a carrier wafer and then to release the bond, typically after some processing of the device wafer.

The support wafer and the bond material must preserve the integrity of the device wafer, during any subsequent processing steps. Acceptable wafer stress and bow, total thickness, adhesion and other properties are important. The removal of the temporary wafer must not induce significant damage and must leave a clean, acceptable surface condition. The bond materials must not contaminate device wafer process tools.

Current support bonds include silicon oxide or metal bonds without a release layer. However, these types of materials and the inorganic bonds formed are generally permanent bonds, and therefore preclude processing flows that require a temporary bond.

Organic materials have poor chemical inertness to basic, oxidizing, and elevated temperature process steps such as a practical GaAs substrate removal etch. However, oxide bonds are inert to basic oxidizing chemistries and are compatible with high temperatures.

Organic materials can exhibit marginal adhesion to some materials resulting in delamination. Organic materials are undesirable contaminants in some processing tools, especially if partial wafers are bonded to full size temporary handle wafers.

Accordingly, there is a need for improved methods and materials to releasably hold a wafer for processing.

### SUMMARY

One or more embodiments of the disclosure are directed to methods of manufacturing a light emitting diode (LED). The methods comprise bonding a transparent support wafer to a growth wafer. The transparent support wafer has a laser lift-off (LLO) release layer formed on a first side of the transparent support wafer and an inorganic bonding layer on the LLO release layer. The growth wafer has a device layer on a second side of the growth wafer and a matching inorganic bonding layer on the device layer. Bonding the transparent support wafer to the growth wafer comprises bonding the inorganic bonding layer on the transparent support wafer with the matching inorganic bonding layer on the growth wafer to form an inorganic processing layer.

Additional embodiments of the disclosure are directed to methods of manufacturing a light emitting diode (LED). The methods comprise depositing an inorganic bonding layer on a device layer on a second side of a growth wafer. A laser lift-off (LLO) release layer is deposited on a first side of a transparent support wafer, and a matching inorganic bonding layer on the LLO release layer. The inorganic bonding layer on the growth wafer is bonded with the matching inorganic bonding layer on the transparent support wafer to form an inorganic processing layer between the transparent support wafer and the growth wafer. The growth wafer is removed from the device layer, leaving the device layer bonded to the inorganic processing layer. A first side of the device layer is processed to form a processed device layer. A second support wafer is attached to the first side of the processed device layer. The processed device layer is separated from the transparent support wafer, leaving the inorganic processing layer on a second side of the processed device layer. The inorganic processing layer is removed from the second side of the device layer.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only typical embodiments of this disclosure and are therefore not to be considered limiting of its scope, for the disclosure may admit to other equally effective embodiments. The embodiments as described herein are illustrated by way of example and not limitation in the figures of the accompanying drawings in which like references indicate similar elements.
FIG. 1 illustrates a flowchart of a processing method according to one or more embodiment of the disclosure; and
FIG. 2A illustrates a schematic cross-sectional view of a device wafer and transparent support wafer before bonding according to one or more embodiment of the disclosure;
FIG. 2B illustrates a schematic cross-sectional view of a device wafer bonded to a transparent support wafer according to one or more embodiment of the disclosure;
FIG. 2C illustrates a schematic cross-sectional view a device layer bonded to a transparent support wafer after removal of the growth wafer according to one or more embodiment of the disclosure;
FIG. 2D illustrates a schematic cross-sectional view of a processed device layer bonded to a transparent support wafer according to one or more embodiment of the disclosure;
FIG. 2E illustrates a schematic cross-sectional view of a processed device layer bonded to a second support wafer and a transparent support wafer according to one or more embodiment of the disclosure;
FIG. 2F illustrates a schematic cross-sectional view of a processed device wafer with a second support wafer after separation from the transparent support wafer according to one or more embodiment;
FIG. 2G illustrates a schematic cross-sectional view of a cleaned processed device wafer with a permanent support wafer and a separate transparent support wafer according to one or more embodiments of the disclosure; and
FIG. 3 illustrates a schematic representation of a transparent support wafer with a plurality of device wafers arranged thereon.

To facilitate understanding, identical reference numerals have been used, where possible, to designate identical elements that are common to the figures. The figures are not drawn to scale. For example, the heights and widths of the various components are not drawn to scale.

### DETAILED DESCRIPTION

Before describing several exemplary embodiments of the disclosure, it is to be understood that the disclosure is not limited to the details of construction or process steps set forth in the following description. The disclosure is capable of other embodiments and of being practiced or being carried out in various ways.

The term "substrate" as used herein according to one or more embodiments refers to a structure, intermediate or final, having a surface, or portion of a surface, upon which a process acts. In addition, reference to a substrate in some embodiments also refers to only a portion of the substrate, unless the context clearly indicates otherwise. Further, reference to depositing on a substrate according to some embodiments includes depositing on a bare substrate, or on a substrate with one or more films or features or materials deposited or formed thereon.

In one or more embodiments, the "substrate" means any substrate or material surface formed on a substrate upon which film processing is performed during a fabrication process. In exemplary embodiments, a substrate surface on which processing is performed includes materials such as silicon, silicon oxide, silicon on insulator (SOI), strained silicon, amorphous silicon, doped silicon, carbon doped silicon oxides, germanium, gallium arsenide, glass, sapphire, and any other suitable materials such as metals, metal nitrides, III-nitrides (e.g., GaN, AlN, InN and alloys), metal alloys, and other conductive materials, depending on the application. Substrates include, without limitation, light emitting diode (LED) devices. Substrates in some embodiments are exposed to a pretreatment process to polish, etch, reduce, oxidize, hydroxylate, anneal, UV cure, e-beam cure and/or bake the substrate surface. In addition to film processing directly on the surface of the substrate itself, in some embodiments, any of the film processing steps disclosed are also performed on an underlayer formed on the substrate, and the term "substrate surface" is intended to include such underlayer as the context indicates. Thus, for example, where a film/layer or partial film/layer has been deposited onto a substrate surface, the exposed surface of the newly deposited film/layer becomes the substrate surface.

The term "wafer" and "substrate" will be used interchangeably in the instant disclosure. Thus, as used herein, a wafer serves as the substrate for the formation of the LED devices described herein.

In some embodiments, the basic drawbacks of organic bonds are overcome with a releasable inorganic bond. The high coefficient of thermal expansion (CTEs) of organic materials (>25ppm/°C) combined with the required bonding layer thickness (>10 µm), imparts excessive stress on thin film device layers during subsequent high temperature process steps. If the device wafer is particularly thin (<20 µm) it may buckle, warp and/or delaminate. However inorganic bonds are much thinner (<3 µm) and have a lower CTE (<25ppm/°C) and the resulting stress is much lower.

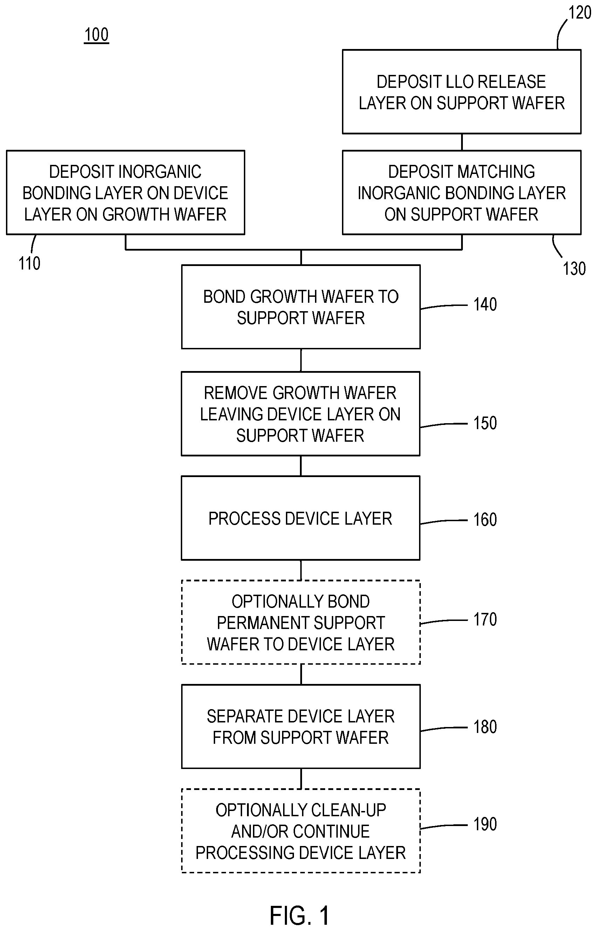

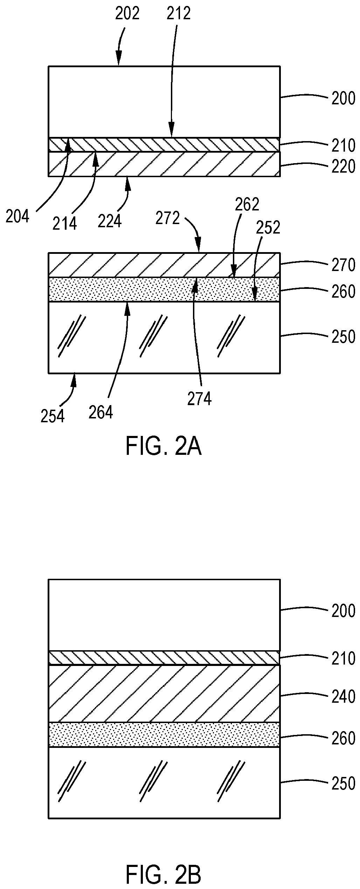

Accordingly, with reference to FIGS. 1 and 2A through 2G, methods 100 for manufacturing electronic devices (e.g., light emitting diodes (LEDs) are disclosed. FIG. 1 illustrates a method 100 of manufacturing a light emitting diode (LED). FIGS. 2A through 2G show schematic cross-sectional representations of the method 100 illustrated in FIG. 1. While the disclosure refers to the device being formed as a light emitting diode, the skilled artisan will recognize that this is merely one possible electronic device and that other electronic or non-electronic devices can be formed by the disclosed processes.

In some embodiments, a growth wafer 200 is bonded to a support wafer 250. The bond is inorganic, e.g. oxide or metallic. In one or more embodiments, between the bond layer and the support wafer 250, there is a release layer 260 that dissociates when exposed to laser radiation of appropriate intensity and wavelength. The support wafer 250 is transparent to the laser radiation which is directed through the support wafer in a stitched pattern that completely covers the bond area. The growth wafer 200 is thereby released from the support wafer 250. The release process is commonly known as Laser Lift-Off (LLO). Embodiments of the disclosure can be used where any wafer process flow requiring temporary mechanical support with subsequent process steps that are incompatible with organic bonding.

A growth wafer 200 having a first side 202 and a second side 204 is illustrated in FIG. 2A. In some embodiments, the second side 204 of the growth wafer 200 has been processed previously to form a device layer 210. In some embodiments, the second side 204 of the growth wafer 200 has not been processed prior to method 100 being performed. The device layer 210 can be any suitable processed layer on the second side 204 of the growth wafer 200. In some embodiments, the device layer 210 is a semiconductor layer including, but not limited to, light emitting diodes (LEDs), transistors, capacitors, portions of light emitting diodes (e.g., active regions), portions of transistors (e.g., channels or doped source/drain regions), wirebond pads, bus bars, reflective layers, current carrying layers, contacts, intentionally roughened surfaces, etc.

At operation 110, the backside (second side 204) of the growth wafer 200 is coated with an inorganic bonding layer 220 (e.g., a metal or oxide material) and prepared for bonding. The device layer 210 forms the second side 204 of the growth wafer 200 at this point in the process so that forming the inorganic bonding layer 220 on the second side 204 of the growth wafer 200 results in the inorganic bonding layer 220 being formed on the device layer 210. Stated differently, the inorganic bonding layer 220 can be formed on the second side 214 of the device layer 210 while the first side 212 of the device layer 210 is formed on the second side 204 of the growth wafer 200.

The inorganic bonding layer 220 of some embodiments is deposited onto the second side 204 of the growth wafer 200 (or the second side 214 of the device layer 210) using any suitable technique known to the skilled artisan, including, but not limited to, physical vapor deposition (PVD), chemical vapor deposition (CVD), atomic layer deposition (ALD), plasma-enhanced chemical vapor deposition (PECVD) or plasma-enhanced atomic layer deposition (PEALD), and spin-on techniques. In some embodiments, the inorganic bonding layer 220 comprises a metal layer and is deposited by physical vapor deposition. In some embodiments, the inorganic bonding layer 220 comprises an oxide and is deposited by ALD, PEALD, CVD or PECVD.

In some embodiments, the growth wafer 200, device layer 210 and inorganic bonding layer 220 is prepared for bonding. In some embodiments, the inorganic bonding layer 220 is prepared for bonding by one or more of polishing the bonding surface 224 and/or protecting the first side 202 (also referred to as the front side) of the growth wafer 200 with a layer of photoresist (not shown).

A transparent support wafer 250 having a first side 252 and a second side 254 is used for temporary support of the growth wafer 200 during processing. The support wafer 250 is a transparent (relative to the laser wavelength required to release the bond formed in subsequent operations). The LLO release layer 260 on the support wafer 250 is suitable for high intensity laser dissociation. This release layer is coated with a bonding layer (metal or oxide) matched to the device wafer and prepared for bonding. In some embodiments, preparing the device wafer includes polishing the bonding surface.

The transparent support wafer 250 can be any suitable material that is transparent to the laser wavelength used for release operations. In some embodiments, the transparent support wafer 250 comprises sapphire, silicon carbide, or glass.

At operation 120, as shown in FIG. 2A, a laser lift-off (LLO) release layer 260 is deposited on the first side 252 of the transparent support wafer 250. The LLO release layer 260 has a first side 262 and a second side 264. In some embodiments, the first side 262 of the LLO release layer 260 is in direct contact with the first side 252 of the transparent support wafer 250. As used in this manner, the term "direct contact" means that there is no intervening material between the stated components.

The LLO release layer 260 of some embodiments comprises one or more of gallium nitride (GaN), aluminum indium gallium nitride having a general formula AlₓIn_{y}Ga_{1-x-y}N, where 0<x+y≤1.0, or indium tin oxide (ITO) having the general formula In_{z}Sn_{1-z}O, where 0≤z≤1.0. In some embodiments, the LLO release layer 260 comprises epitaxially grown gallium nitride (GaN). In some embodiments, the LLO release layer 260 comprises ITO deposited by one or more of sputtering or evaporation.

The LLO release layer 260 can have any suitable thickness and be deposited by any suitable technique known to the skilled artisan. In some embodiments, the LLO release layer 260 has a thickness greater than or equal to 100 Å. In some embodiments, the LLO release layer 260 is deposited by one or more of epitaxy, sputtering, evaporation, plasma-enhanced chemical vapor deposition (PECVD) or metal organic vapor deposition (MOCVD).

At operation 130, a matching inorganic bonding layer 270 is formed on the LLO release layer 260. The matching inorganic bonding layer 270 of some embodiments comprises the same material as the inorganic bonding layer 220 formed on the growth wafer 200. The matching inorganic bonding layer 270 has a first surface 272 and a second side 274. In some embodiments, the matching inorganic bonding layer 270 is formed on the first side 262 of the LLO release layer 260 so that the second side 274 of the matching inorganic bonding layer 270 is in direct contact with the first side 262 of the LLO release layer 260.

In some embodiments, the matching inorganic bonding layer 270 comprises a different material than the inorganic bonding layer 220. The matching inorganic bonding layer 270 may comprise one or more metallic elements while inorganic bonding layer 220 comprises different metallic elements, which upon heating in direct contact intermix to form a metallic alloy bond. The metal layers may be chosen such that the alloy formed has a higher melting point than one of the constituent elements, for example Au and In forming a Auln alloy. Numerous possible examples are readily found in the practice of soldering. In one or more embodiments of this sort, the matching inorganic bonding layer 270 is a material that is compatible with the inorganic bonding layer 220 and may improve adhesion between the inorganic bonding layer 220 and the matching inorganic bonding layer 270. In some embodiments, a very thin titanium (Ti) layer is formed between inorganic bonding layer 220 and the matching inorganic bonding layer 270. As used in this manner, a "very thin" layer refers to a layer with a thickness less than or equal to 20 Å.

In some embodiments, the inorganic bonding layer 220 and matching inorganic bonding layer 270 comprise silicon oxide (SiOₓ). In some embodiments, the SiOx is replaced by other oxides which have superior HF resistance or other properties.

In some embodiments, the matching inorganic bonding layer 270 comprises a silicon oxide layer formed directly on the LLO release layer 260 on the first side 252 of the transparent support wafer 250. In some embodiments, each of the inorganic bonding layer 220 and the matching inorganic bonding layer 270 independently have a final thickness in the range of 200Å to 400Å. In some embodiments, the inorganic bonding layer 220 and matching inorganic bonding layer 270 are deposited and then polished. In some embodiments, the bonding layers are deposited with a thickness greater than 500Å and polishing brings the thickness down.

The inorganic bonding layer 220 and matching inorganic bonding layer 270 can be deposited by any suitable technique known to the skilled artisan. In some embodiments, each of the inorganic bonding layer 220 and matching inorganic bonding layer 270 are deposited by physical vapor deposition (PVD), plasma-enhanced chemical vapor deposition (PECVD) or ebeam evaporation.

The order of the operations 110, 120/130 to prepare the growth wafer and the support wafer for bonding can be varied. For example, depositing the inorganic bonding layer on the device wafer (operation 110) can occur before, after or at the same time as depositing the LLO release layer on the support wafer (operation 120) and/or depositing the matching inorganic bonding layer on the support wafer (operation 130). Stated differently, preparation of the device wafer and the support wafer occur independently so that the order can be varied.

After the growth wafer 200 and transparent support wafer 250 have been prepared (i.e., the bonding layers have been prepared), at operation 140, the inorganic bonding layer 220 on the growth wafer 200 is bonded with the matching inorganic bonding layer 270 on the transparent support wafer 250 to form an inorganic processing layer 240 between the transparent support wafer 250 and the growth wafer 200, as shown in FIG. 2B.

The inorganic bonding layer 220 can be bonded to the matching inorganic bonding layer 270 by any suitable technique at any suitable temperature known to the skilled artisan. In some embodiments, bonding of the inorganic bonding layer 220 and the matching inorganic bonding layer 270 occurs at room temperature. In some embodiments, bonding of the inorganic bonding layer 220 and the matching inorganic bonding layer 270 occurs at a temperature up to and including 400 °C. Without being bound by any particular theory of operation, it is believed that increased temperature accelerates the bonding process and densifies and/or improves the bond strength.

The method 100 up to this point results in the bonding of a transparent support wafer 250 to a growth wafer 200, in which the transparent support wafer 250 has a laser lift-off (LLO) release layer 260 formed on a first side 252 of the transparent support wafer 250 and an inorganic bonding layer 270 on the LLO release layer 260. The growth wafer 200 has an inorganic bonding layer 220 on a second side 204 of the growth wafer 200 (or the second side 214 of the device layer 210 formed on the second side 204 of the growth wafer 200). The bonding of the transparent support wafer 250 to the growth wafer 200 comprises bonding the inorganic bonding layer 270 on the transparent support wafer 250 with the inorganic bonding layer 220 on the growth wafer 200 to form an inorganic processing layer 240.

In some embodiments, the inorganic bonding layer 220, the matching inorganic bonding layer 270 and the inorganic processing layer 240 comprise silicon oxide (SiOₓ), and the transparent support wafer 250 comprises sapphire. In some embodiments, a very thin titanium layer is formed on one or more of the inorganic bonding layer 220 or matching inorganic bonding layer 270 prior to bonding so that there is a thin layer of titanium (not shown) within the thickness of the inorganic processing layer 240.

In some embodiments, the inorganic processing layer 240 has a total thickness less than or equal to 5 µm. In some embodiments, the inorganic processing layer 240 has a total thickness less than or equal to 4 µm, 3 µm, 2 µm, 1.5 µm or 1 µm. In some embodiments, the total thickness of the inorganic processing layer 240 is 1.3 µm ± 0.5 µm.

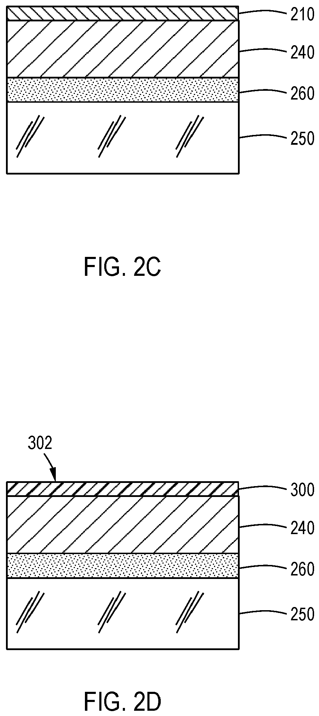

At operation 150, as shown in FIG. 2C, after the growth wafer 200 is bonded to the transparent support wafer 250, the growth wafer 200 is removed. Removing the growth wafer 200 leaves the device layer 210 attached to the inorganic processing layer 240, LLO release layer 260 and transparent support wafer 250. Removing the growth wafer 200 exposes the first side 212 of the device layer 210 for further processing, while protecting the second side 214 of the device layer 210.

The growth wafer 200 can be separated from the device layer 210 by any suitable technique. For example, suitable techniques include but are not limited to grinding, chemical-mechanical polishing, laser lift-off (LLO), and/or wet etching to remove the growth wafer 200.

At operation 160, as shown in FIG. 2D, one or more process steps are executed on the first side 212 of the device layer 210. The support wafer 250 and any exposed bond material are chosen to be relatively unaffected by the process steps and not contaminate the processing tool or interfere with the processing. Processing of the device layer 210 is performed via the first side 212 of the device layer 210 to form a processed device layer 300.

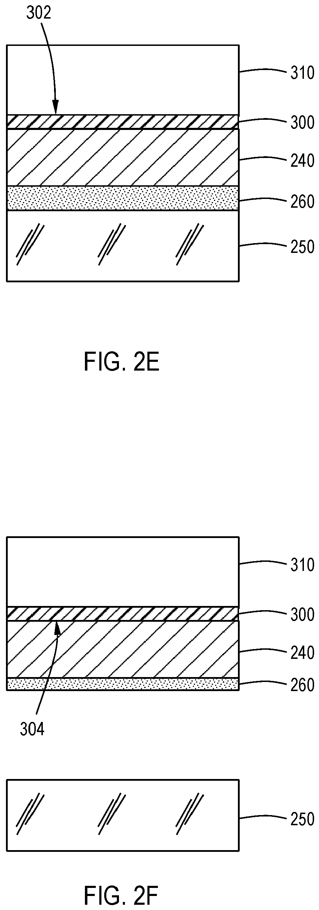

In some embodiments, optional operation 170 is performed to bond a second support wafer 310 to the first side 302 of the processed device layer 300, as shown in FIG. 2E. After completion of the device layer processing, a second permanent or temporary support wafer can be attached to the first side 302 of the processed device layer 300.

At operation 180, the processed device layer 300 is separated from the transparent support wafer 250, as shown in FIG. 2F. In some embodiments, the separation process leaves the inorganic processing layer 240 on the second side 304 of the processed device layer 300.

In some embodiments, separating the processed device layer 300 from the transparent support wafer 250 comprises dissociating the LLO release layer 260 using laser pulses leaving the inorganic processing layer 240 on a second side 304 of the processed device layer 300.

In some embodiments, a stitched pattern of high intensity pulses is used to release the device wafer (Laser Lift-Off). In some embodiments, the LLO release layer 260 comprises gallium nitride (GaN) which dissociates into gallium (Ga) and molecular nitrogen (N₂). In some embodiments, a 248nm Ar⁺ Excimer laser is used to expose the GaN layer to release the processed device layer 300 from the support wafer 250.

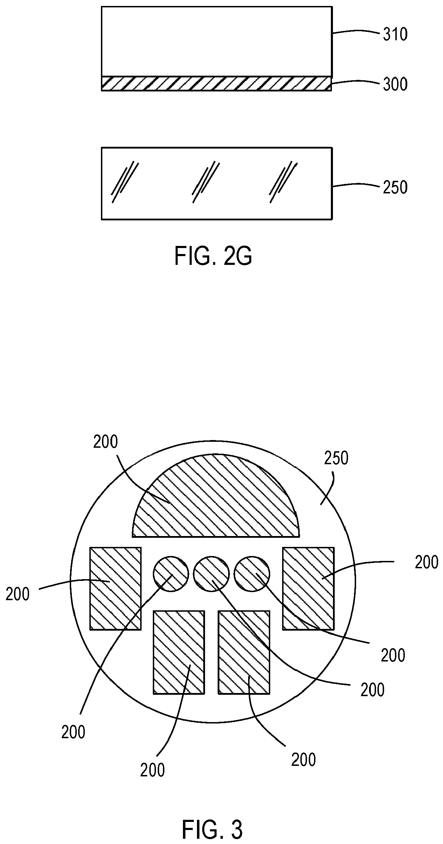

At operation 180, the processed device layer 300 is cleaned to remove any residual LLO release layer 260 and inorganic processing layer 240, as shown in FIG. 2G. The result of method 100 is a processed device layer 300 with an optional permanent or temporary support (second support wafer 310) and a separate transparent support wafer 250.

In some embodiments, as illustrated in FIG. 2F, an amount of the LLO release layer 260 remains on the inorganic processing layer 240. Optional operation 190 can be used to clean-up the residual LLO release layer 260 and/or perform additional processing steps on processed device layer 300. The residual LLO release layer 260 can be removed from the inorganic processing layer 240 in a separate process, or in the same process, as removal of the inorganic processing layer 240 from the processed device layer 300.

In some embodiments, the transparent support wafer 250 is reusable after dissociating the LLO release layer 260.

In one or more embodiments, an adhesion promoting layer (not shown) is added between the inorganic bonding layers 220 and matching bonding layer 270 and the growth wafer 200 and/or transparent support wafers 250. The adhesion promoting layer can be any suitable material that increases the adhesion of the bonding layer material with the underlying layers. Suitable adhesion promoting layer include, but are not limited to, titanium (Ti) or silicon nitride.

Some embodiments of the disclosure are used with partial wafers. The partial wafers can be attached to a full-size carrier by oxide (or other suitable) bonding. Additionally, with the addition of support wafers on the frontside of the device wafer (post-processing) the process can be used to fabricate Thin Film Flip Chip or Chip Scale Packaged Devices where the growth substrates must be removed before device completion.

For example, FIG. 3 shows a schematic representation of a top-down view of a transparent support wafer 250 with a plurality of growth wafers 200 arranged on the transparent support wafer 250. The number of growth wafers 200 illustrated is merely representative of one possible configuration and the skilled artisan will recognize that any suitable number of device wafers or portions of device wafers can be arranged on the transparent support wafer 250 depending on, for example, the size of the device wafers and transparent support wafer. In some embodiments, there are more than one growth wafer 200 on a single transparent support wafer 250.

In the illustrated embodiment, the growth wafers 200 are shown on the first side 252 of the transparent support wafer 250. After processing the device layers, the LLO release layer 260 is removed by illuminating through the transparent support wafer 250.

Embodiment 1. A method (100) of manufacturing a light emitting diode (LED), the method comprising: bonding a transparent support wafer (250) to a growth wafer (200), the transparent support wafer (250) having a laser lift-off (LLO) release layer (260) formed on a first side (252) of the transparent support wafer (250) and an inorganic bonding layer (270) on the LLO release layer (260), the growth wafer (200) having a device layer (210) on a second side (204) of the growth wafer (200) and a matching inorganic bonding layer (220) on the device layer (210), wherein bonding the transparent support wafer (250) to the growth wafer (200) comprises bonding the inorganic bonding layer (270) on the transparent support wafer (250) with the matching inorganic bonding layer (220) on the growth wafer (200) to form an inorganic processing layer (240).

Embodiment 2. The method of embodiment 1, further comprising removing the growth wafer (200), leaving the device layer (210) on the inorganic processing layer (240) on the LLO release layer (260) on the transparent support wafer (250).

Embodiment 3. The method of embodiment 2, further comprising processing the device layer (210) via a first side (212) of the device layer (210) to form a processed device layer (300).

Embodiment 4. The method of embodiment 3, further comprising attaching a second support wafer (310) to a second side (304) of the processed device layer (300).

Embodiment 5. The method of embodiment 4, further comprising separating the processed device layer (300) from the transparent support wafer (250).

Embodiment 6. The method of embodiment 5, wherein separating the processed device layer (300) from the transparent support wafer (250) comprises dissociating the LLO release layer (260) using laser pulses leaving the inorganic processing layer (240) on a second side (304) of the processed device layer (300).

Embodiment 7. The method of embodiment 5 or 6, wherein the transparent support wafer (250) is reusable after dissociating the LLO release layer (260).

Embodiment 8. The method of any of embodiments 5 to 7, further comprising removing the inorganic processing layer (240) from the second side (204) of the processed device layer (300).

Embodiment 9. The method of any of embodiments 1 to 8, wherein the LLO release layer (260) comprises one or more of gallium nitride (GaN), aluminum indium gallium nitride having a general formula Alₓₗn_{y}Ga_{1-x-y}N, where 0<x+y≤1.0, or indium tin oxide having the general formula In_{z}Sn_{1-z}O, where 0≤z≤1.0.

Embodiment 10. The method of any of embodiments 1 to 9, wherein the LLO release layer (260) has a thickness greater than or equal to 100 Å.

Embodiment 11. The method of any of embodiments 1 to 10, wherein the transparent support wafer (250) comprises sapphire, silicon carbide, or glass.

Embodiment 12. The method of any of embodiments 1 to 11, wherein a silicon oxide layer is formed directly on the LLO release layer (260) on the first side (252) of the transparent support wafer (250).

Embodiment 13. The method of any of embodiments 1 to 12, wherein each of the inorganic bonding layer (220) and the matching inorganic bonding layer (270) are deposited by physical vapor deposition.

Embodiment 14. The method of any of embodiments 1 to 13, wherein the LLO release layer (260) is deposited by metal organic vapor deposition (MOCVD).

Embodiment 15. The method of any of embodiments 1 to 14, further comprising depositing the inorganic bonding layer (220) on the second side (204) of the growth wafer (200).

Embodiment 16. The method of any of embodiments 1 to 15, further comprising depositing the LLO release layer (260) on the transparent support wafer (250) and the matching bonding layer (270) on the LLO release layer (260).

Embodiment 17. The method of any of embodiments 1 to 16, wherein there are a plurality of growth wafers (200) bonded to one transparent support wafer (250).

Embodiment 18. A method of manufacturing a light emitting diode (LED), the method comprising: depositing an inorganic bonding layer (220) on a device layer (210) on a second side (204) of a growth wafer (200); depositing a laser lift-off (LLO) release layer (260) on a first side (252) of a transparent support wafer (250), and a matching inorganic bonding layer (270) on the LLO release layer (260); bonding the inorganic bonding layer (220) on the growth wafer (200) with the matching inorganic bonding layer (270) on the transparent support wafer (250) to form an inorganic processing layer (240) between the transparent support wafer (250) and the growth wafer (200); removing the growth wafer (200) from the device layer (210), leaving the device layer (210) bonded to the inorganic processing layer (240); processing a first side (212) of the device layer (210) to form a processed device layer (300); attaching a second support wafer (310) to the first side (302) of the processed device layer (300); separating the processed device layer (300) from the transparent support wafer (250), leaving the inorganic processing layer (240) on a second side (304) of the processed device layer (300); and removing the inorganic processing layer (240) from the second side (304) of the device layer (210).

Embodiment 19. The method of embodiment 18, wherein separating the processed growth wafer (200) from the transparent support wafer (250) comprises dissociating the LLO release layer (260) using laser pulses leaving the inorganic processing layer (240) on a second side (304) of the processed device layer (300).

Embodiment 20. The method of embodiment 18 or 19, wherein the transparent support wafer (250) is reusable after dissociating the LLO release layer (260).

Embodiment 21. The method of any of embodiments 18 to 20, wherein the LLO release layer (260) comprises one or more of gallium nitride (GaN), aluminum indium gallium nitride having a general formula AlxlnyGa1-x-yN, where 0<x+y≤1.0, or indium tin oxide having the general formula In_{z}Sn_{1-z}O, where 0≤z≤1.0.

Embodiment 22. The method of any of embodiments 18 to 21, wherein the LLO release layer (260) has a thickness greater than or equal to 100 Å.

Embodiment 23. The method of any of embodiments 18 to 22, wherein the transparent support wafer (250) comprises sapphire, silicon carbide or glass.

Embodiment 24. The method of any of embodiments 18 to 23, wherein a silicon oxide layer is formed directly on the LLO release layer (260) on the first side (252) of the transparent support wafer (250).

Embodiment 25. The method of any of embodiments 18 to 23, wherein each of the inorganic bonding layer (220) and the matching inorganic bonding layer (270) are deposited by physical vapor deposition.

The use of the terms "a" and "an" and "the" and similar referents in the context of describing the materials and methods discussed herein (especially in the context of the following claims) are to be construed to cover both the singular and the plural, unless otherwise indicated herein or clearly contradicted by context. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the materials and methods and does not pose a limitation on the scope unless otherwise claimed. No language in the specification should be construed as indicating any non-claimed element as essential to the practice of the disclosed materials and methods.

Reference throughout this specification to "one embodiment," "certain embodiments," "one or more embodiments" or "an embodiment" means that a particular feature, structure, material, or characteristic described in connection with the embodiment is included in at least one embodiment of the disclosure. Thus, the appearances of the phrases such as "in one or more embodiments," "in certain embodiments," "in one embodiment" or "in an embodiment" in various places throughout this specification are not necessarily referring to the same embodiment of the disclosure. In one or more embodiments, the particular features, structures, materials, or characteristics are combined in any suitable manner.

Although the disclosure herein has been described with reference to particular embodiments, it is to be understood that these embodiments are merely illustrative of the principles and applications of the present disclosure. It will be apparent to those skilled in the art that various modifications and variations can be made to the method and apparatus of the present disclosure without departing from the spirit and scope of the disclosure. Thus, it is intended that the present disclosure include modifications and variations that are within the scope of the appended claims and their equivalents.

Furthermore, the following further exemplary embodiments of the invention are disclosed:
Embodiment 1: A method of manufacturing a light emitting diode (LED), the method comprising:
   bonding a transparent support wafer to a growth wafer, the transparent support wafer having a laser lift-off (LLO) release layer formed on a first side of the transparent support wafer and an inorganic bonding layer on the LLO release layer, the growth wafer having a device layer on a second side of the growth wafer and a matching inorganic bonding layer on the device layer, wherein bonding the transparent support wafer to the growth wafer comprises bonding the inorganic bonding layer on the transparent support wafer with the matching inorganic bonding layer on the growth wafer to form an inorganic processing layer.
Embodiment 2: The method of embodiment 1, further comprising removing the growth wafer, leaving the device layer on the inorganic processing layer on the LLO release layer on the transparent support wafer.
Embodiment 3: The method of embodiment 2, further comprising processing the device layer via a first side of the device layer to form a processed device layer.
Embodiment 4: The method of embodiment 3, further comprising attaching a second support wafer to a second side of the processed device layer.
Embodiment 5: The method of embodiment 4, further comprising separating the processed device layer from the transparent support wafer.
Embodiment 6: The method of embodiment 5, wherein separating the processed device layer from the transparent support wafer comprises dissociating the LLO release layer using laser pulses leaving the inorganic processing layer on a second side of the processed device layer.
Embodiment 7: The method of embodiment 5, wherein the transparent support wafer is reusable after dissociating the LLO release layer.
Embodiment 8: The method of embodiment 5, further comprising removing the inorganic processing layer from the second side of the processed device layer.
Embodiment 9: The method of embodiment 1, wherein the LLO release layer comprises one or more of gallium nitride (GaN), aluminum indium gallium nitride having a general formula AlₓIn_{y}Ga_{1-x-y}N, where 0<x+y≤1.0, or indium tin oxide having the general formula In_{z}Sn_{1-z}O, where 0≤z≤1.0.
Embodiment 10: The method of embodiment 1, wherein the LLO release layer has a thickness greater than or equal to 100 Å.
Embodiment 11: The method of embodiment 1, wherein the transparent support wafer comprises sapphire, silicon carbide, or glass.
Embodiment 12: The method of embodiment 1, wherein a silicon oxide layer is formed directly on the LLO release layer on the first side of the transparent support wafer.
Embodiment 13: The method of embodiment 1, further comprising depositing the inorganic bonding layer on the second side of the growth wafer.
Embodiment 14: The method of embodiment 1, further comprising depositing the LLO release layer on the transparent support wafer and the matching bonding layer on the LLO release layer.
Embodiment 15: The method of embodiment 1, wherein there are a plurality of growth wafers bonded to one transparent support wafer.
Embodiment 16: A method of manufacturing a light emitting diode (LED), the method comprising:
   depositing an inorganic bonding layer on a device layer on a second side of a growth wafer;
   depositing a laser lift-off (LLO) release layer on a first side of a transparent support wafer, and a matching inorganic bonding layer on the LLO release layer;
   bonding the inorganic bonding layer on the growth wafer with the matching inorganic bonding layer on the transparent support wafer to form an inorganic processing layer between the transparent support wafer and the growth wafer;
   removing the growth wafer from the device layer, leaving the device layer bonded to the inorganic processing layer;
   processing a first side of the device layer to form a processed device layer;
   attaching a second support wafer to the first side of the processed device layer;
   separating the processed device layer from the transparent support wafer, leaving the inorganic processing layer on a second side of the processed device layer; and
   removing the inorganic processing layer from the second side of the device layer.
Embodiment 17: The method of embodiment 16, wherein separating the processed growth wafer from the transparent support wafer comprises dissociating the LLO release layer using laser pulses leaving the inorganic processing layer on a second side of the processed device layer.
Embodiment 18: The method of embodiment 17, wherein the transparent support wafer is reusable after dissociating the LLO release layer.
Embodiment 19: The method of embodiment 16, wherein the LLO release layer comprises one or more of gallium nitride (GaN), aluminum indium gallium nitride having a general formula AlₓIn_{y}Ga_{1-x-y}N, where 0<x+y≤1.0, or indium tin oxide having the general formula In_{z}Sn_{1-z}O, where 0≤z≤1.0.
Embodiment 20: The method of embodiment 16, wherein the transparent support wafer comprises sapphire, silicon carbide or glass.

## Claims

1. A method of manufacturing a light emitting diode (LED), the method comprising:
bonding a transparent support wafer to a growth wafer, the transparent support wafer having a laser lift-off (LLO) release layer formed on a first side of the transparent support wafer and an inorganic bonding layer on the LLO release layer, the growth wafer having a device layer on a second side of the growth wafer and a matching inorganic bonding layer on the device layer, wherein bonding the transparent support wafer to the growth wafer comprises bonding the inorganic bonding layer on the transparent support wafer with the matching inorganic bonding layer on the growth wafer to form an inorganic processing layer.

2. The method of claim 1, further comprising removing the growth wafer, leaving the device layer on the inorganic processing layer on the LLO release layer on the transparent support wafer.

3. The method of claim 2, further comprising processing the device layer via a first side of the device layer to form a processed device layer.

4. The method of claim 3, further comprising attaching a second support wafer to a second side of the processed device layer.

5. The method of claim 4, further comprising separating the processed device layer from the transparent support wafer.

6. The method of claim 5, further comprising removing the inorganic processing layer from the second side of the processed device layer.

7. The method of claim 1, wherein the LLO release layer has a thickness greater than or equal to 100 Å.

8. The method of claim 1, wherein a silicon oxide layer is formed directly on the LLO release layer on the first side of the transparent support wafer.

9. The method of claim 1, further comprising depositing the inorganic bonding layer on the second side of the growth wafer.

10. The method of claim 1, further comprising depositing the LLO release layer on the transparent support wafer and the matching bonding layer on the LLO release layer.

11. A method of manufacturing a light emitting diode (LED), the method comprising:
depositing an inorganic bonding layer on a device layer on a second side of a growth wafer;
depositing a laser lift-off (LLO) release layer on a first side of a transparent support wafer, and a matching inorganic bonding layer on the LLO release layer;
bonding the inorganic bonding layer on the growth wafer with the matching inorganic bonding layer on the transparent support wafer to form an inorganic processing layer between the transparent support wafer and the growth wafer;
removing the growth wafer from the device layer, leaving the device layer bonded to the inorganic processing layer;
processing a first side of the device layer to form a processed device layer;
attaching a second support wafer to the first side of the processed device layer;
separating the processed device layer from the transparent support wafer, leaving the inorganic processing layer on a second side of the processed device layer; and
removing the inorganic processing layer from the second side of the device layer.

12. The method of claim 11 or of claim 5, wherein separating the processed growth wafer or the processed device layer from the transparent support wafer comprises dissociating the LLO release layer using laser pulses leaving the inorganic processing layer on a second side of the processed device layer.

13. The method of claim 12 or of claim 5, wherein the transparent support wafer is reusable after dissociating the LLO release layer.

14. The method of claim 11 or of claim 1, wherein the LLO release layer comprises one or more of gallium nitride (GaN), aluminum indium gallium nitride having a general formula AlₓIn_{y}Ga_{1-x-y}N, where 0<x+y≤1.0, or indium tin oxide having the general formula In_{z}Sn_{1-z}O, where 0≤z≤1.0.

15. The method of claim 11 or of claim 1, wherein the transparent support wafer comprises sapphire, silicon carbide or glass.
